# EUROPEAN PATENT APPLICATION

(11) **EP 2 618 441 A1**
(43) Date of publication of application: **24.07.2013**
(21) Application number: 12163271.5
(22) Date of filing: 05.04.2012
(51) Int. Cl.: H02H 7/20, H01H 83/02, H01H 83/22, H02H 3/10, H01H 83/04

(54) **Method of operating integrated circuit breaker module for solar power system**

(30) Priority: 19.01.2012 CN 201210016986
(71) Applicant: Delta Electronics, Inc., Taoyuan County 32063 (TW)
(72) Inventor: Hsiao, Wu-Hua, 32063 Taoyuan County (TW)
(74) Representative: 2K Patentanwälte Blasberg Kewitz & Reichel

(57) **Abstract**

A method of operating an integrated circuit breaker module (10) for a solar power system includes following steps: a first circuit breaker (102) is used to provide a short-circuit trip protection (S100); a second circuit breaker (104) is used to provide a grounding-fault trip protection (S200); the first circuit breaker (102) and the second circuit breaker (104) are integrated to form a modular structure and a linking unit is connected between the first circuit breaker (102) and the second circuit breaker (104) to provide a linking trip operation (S300); and the second circuit breaker (104) trips and the first circuit breaker (102) is simultaneously tripped via the linking unit when a grounding fault occurs (S400). Accordingly, a grounding fault protection, an over-current fault protection, and a short-circuit fault protection are implemented.

## Description

### BACKGROUND OF THE INVENTION

### Field of the Invention

The present invention relates generally to a method of operating a circuit breaker module, and more particularly to a method of operating an integrated circuit breaker module with a grounding fault protection and a short-circuit fault protection for a solar power system.

### Description of Prior Art

After the second energy crisis occurred in 1970s, many countries make efforts in seeking and researching alternative sources. Basically, the alternative sources include wind energy, solar energy, geothermal energy, tidal energy, ocean current energy, but without involving coal, petroleum, natural gas, and nuclear energy. Because the solar energy has the pollution-free and public harm-free characteristics and is further inexhaustible in supply and always available for use, the solar energy has high potential applications and developments. Recently with the rapidly development of the high-efficiency solar cells, this topic has been gradually promoted by making policies in many developed countries, such as Europe countries, the United States, Japan, and so on.

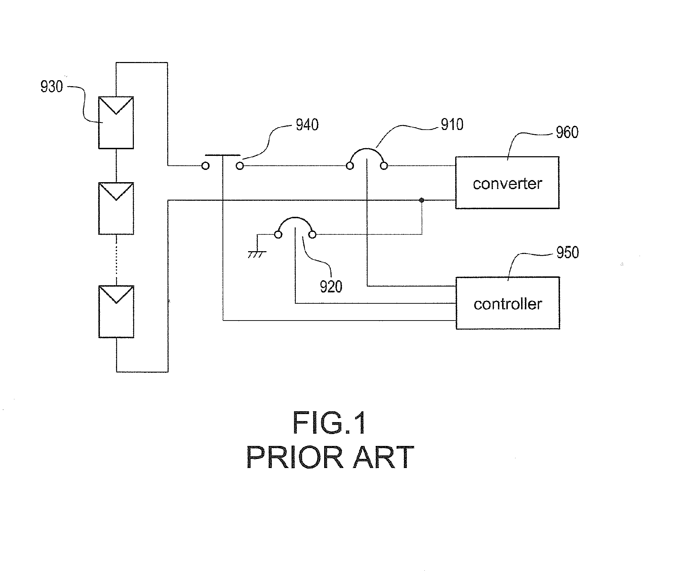

Reference is made to Fig. 1 which is a schematic circuit diagram of providing short-circuit fault and grounding fault protections from a prior art solar power system. In this embodiment, a converter 960 is supplied by a photovoltaic panel assembly 930 which is composed of a plurality of photovoltaic panels. In particular, the converter 960 could be a PV charger with a DC output voltage or an inverter with an AC output voltage. An insulation-detecting mechanism on a path between the photovoltaic panel assembly 930 and the converter 960 is generally provided to meet safety standards so that the required elements or apparatuses for short-circuit fault protection and grounding fault protection need to install. In this embodiment, a first circuit breaker 910 is used to provide a short-circuit fault protection and a second circuit breaker 920 is used to provide a grounding fault protection. In addition, a disconnect switch 940 is further used. The disconnect switch 940 is usually installed on a path which is often associated with the installation of the second circuit breaker 920 on a different path. As shown in Fig. 1, the disconnect switch 940 is electrically connected in series to the first circuit breaker 910. When a controller 950 detects that the second circuit breaker 920 is tripped because of the abnormal grounding fault, the controller 950 turns off the disconnect switch 940 and alarms users to confirm line conditions.

In the prior art circuit structure, however, the first circuit breaker 910, the second circuit breaker 920, and the disconnect switch 940 are essential components for simultaneously providing a grounding fault protection, an over-current fault protection, and a short-circuit fault protection for the solar power system. Accordingly, it is difficult and complex to install, detect, and control the circuits as well as increase costs because of increased components.

Accordingly, it is desirable to provide a method of operating an integrated circuit breaker module for a solar power system to integrate circuit breakers with different rated trip currents. Also, the linking unit provides a predetermined force to simultaneously trip the circuit breakers. Therefore, the solar power system can be completely protected as soon as abnormal faults occur.

### SUMMARY OF THE INVENTION

An object of the invention is to provide a method of operating an integrated circuit breaker module for a solar power system to solve the above-mentioned problems.

The integrated circuit breaker module is operated in a solar power system and provides a grounding fault operation, an over-current fault protection, and a short-circuit fault protection. The method includes steps as follows: (a) a first circuit breaker is used to provide a short-circuit fault protection under a high-rated current operation; (b) a second circuit breaker is used to provide a grounding fault protection under a low-rated current operation; (c) the first circuit breaker and the second circuit breaker are integrated into a module, a linking unit is provided, and the linking unit is connected between the first circuit breaker and the second circuit breaker to simultaneously trip the first circuit breaker and the second circuit breaker; (d) the second circuit breaker is tripped and the first circuit breaker is simultaneously tripped to execute a grounding fault protection, an over-current fault protection, and a short-circuit fault protection when a grounding fault occurs in the solar power system.

It is to be understood that both the foregoing general description and the following detailed description are exemplary, and are intended to provide further explanation of the invention as claimed. Other advantages and features of the invention will be apparent from the following description, drawings and claims.

### BRIEF DESCRIPTION OF DRAWING

The features of the invention believed to be novel are set forth with particularity in the appended claims. The invention itself, however, may be best understood by reference to the following detailed description of the invention, which describes an exemplary embodiment of the invention, taken in conjunction with the accompanying drawings, in which:
Fig. 1 is a schematic circuit diagram of providing short-circuit fault and grounding fault protections from a prior art solar power system;
Fig. 2 is a flowchart of a method of operating an integrated circuit breaker module according to the present invention;
Fig. 3 is a schematic circuit block diagram of an integrated circuit breaker module according to the present invention;
Fig. 4 is a schematic circuit block diagram of applying the integrated circuit breaker module in a low-voltage solar power system according to the present invention; and
Fig. 5 is a schematic circuit block diagram of applying the integrated circuit breaker module in a high-voltage solar power system according to the present invention.

### DETAILED DESCRIPTION OF THE INVENTION

Reference will now be made to the drawing figures to describe the present invention in detail.

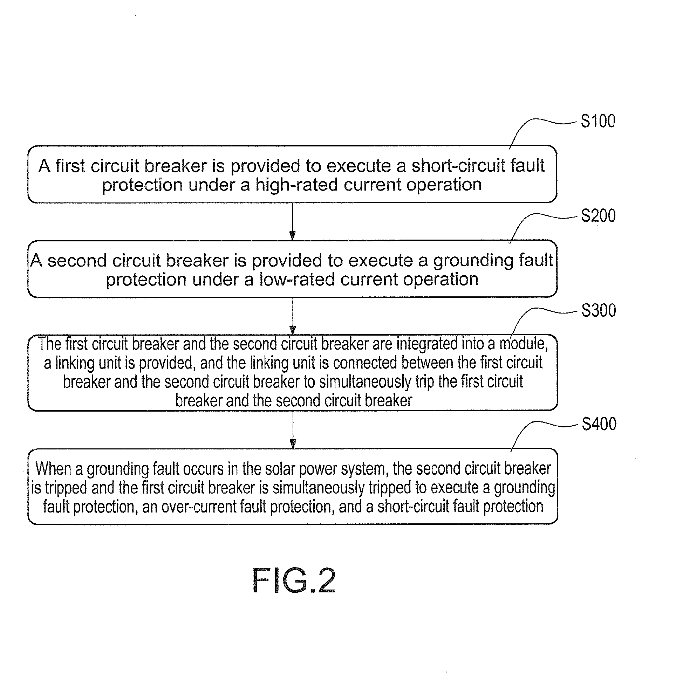

Reference is made to Fig. 2 which is a flowchart of a method of operating an integrated circuit breaker module according to the present invention. The integrated circuit breaker module is operated in a solar power system and provides a grounding fault protection, an over-current fault protection, and a short-circuit fault protection. The method includes steps as follows:
A first circuit breaker is provided to execute a short-circuit fault protection under a high-rated current operation (S100). A second circuit breaker is provided to execute a grounding fault protection under a low-rated current operation (S200). When the solar power system normally operates, a phase current of the second circuit breaker is equal to a neutral current thereof. However, a leakage current is produced and flows through a grounding wire once the solar power system operates under the abnormal grounding fault because of the wire insulation deterioration. Note that, the leakage current is generally small, which is typically milliampere in unit. Hence, the rated current of tripping the second circuit breaker is set not too much for providing the grounding fault protection. For practical applications, the rated current of the second circuit breaker could be set as one ampere, but not limited. Comparing to the leakage current, however, a short-circuit current is larger, which is typically ampere in unit. Hence, the rated current of tripping the first circuit breaker is required to set higher for providing the short-circuit fault protection. For practical applications, the rated current of the first circuit breaker could be set as fifteen amperes, but not limited. Note that, the rated current of the first circuit breaker is set more than ten times of the rated current of the second circuit breaker.

The first circuit breaker and the second circuit breaker are integrated into a module, a linking unit is provided, and the linking unit is connected between the first circuit breaker and the second circuit breaker to simultaneously trip the first circuit breaker and the second circuit breaker (S300). For existing technologies, a number of circuit breakers which have the same (or almost the same) rated current or the same (or almost the same) interrupt current are connected in series or in parallel by shorting output terminals of the circuit breakers in series or in parallel to increase withstanding voltage and rated current. Especially to the main technique feature of the present invention, the first circuit breaker and the second circuit breaker with a large rated current difference which is more than ten times are integrated into a module and the lining unit is provided to simultaneously trip the first circuit breaker and the second circuit breaker.

When a grounding fault occurs in the solar power system, the second circuit breaker is tripped and the first circuit breaker is simultaneously tripped to execute a grounding fault protection, an over-current fault protection, and a short-circuit fault protection (S400). In particular, one terminal of the second circuit breaker is grounded for the grounding fault protection operation. Hence, the leakage current would flow through the second circuit breaker to the grounding wire once the solar power system operates under the abnormal grounding fault because of the wire insulation deterioration, thus providing the grounding fault protection. Note that, in these embodiments of the present invention, the linking unit provides a predetermined force to simultaneously trip the circuit breakers with different rated current values based on meeting safety standards.

In addition, the first circuit breaker is tripped and the second circuit breaker is simultaneously tripped to execute the grounding fault protection, the over-current fault protection, and the short-circuit fault protection when a short-circuit fault occurs in the solar power system. In other words, the second circuit breaker is simultaneously tripped when the first circuit breaker is tripped to provide fault protections, and vice versa, thus completely protecting the solar power system as soon as abnormal faults occur. Therefore, the photovoltaic panel assembly is isolated from rear-end circuits to ensure life safety and property security of humans when faults occur in the solar power system, more particularly to the grounding fault, the over-current fault, and the short-circuit fault.

Especially to deserve to be mentioned, the first circuit breaker has an auxiliary switch or an alarm switch therein. The auxiliary switch is used to detect conditions of turning on or turning off the first circuit breaker. The alarm switch is used to detect causes of manual tripping or overloading automatic tripping the first circuit breaker, such as the grounding fault, the over-current fault, and the short-circuit fault, or so on. Similarly, the second circuit breaker has an auxiliary switch or an alarm switch therein. The auxiliary switch is used to detect conditions of turning on or turning off the second circuit breaker. The alarm switch is used to detect causes of manual tripping or overloading automatic tripping the second circuit breaker, such as the grounding fault, the over-current fault, the short-circuit fault, or so on. In this embodiment, the second circuit breaker has the alarm switch for judging causes of manual tripping or overloading automatic tripping the second circuit breaker when the second circuit breaker is operated under an abnormal fault condition. In particular, the auxiliary switch of the first circuit breaker and the auxiliary switch of the second circuit breaker are controlled by a control unit to detect conditions of turning on or turning off the first circuit breaker and the second circuit breaker, respectively. Furthermore, the alarm switch of the first circuit breaker and the alarm switch of the second circuit breaker are controlled by a control unit to detect causes of manual tripping or overloading automatic tripping the first circuit breaker and second circuit breaker, respectively, such as the grounding fault, the over-current fault, the short-circuit fault, or so on. In particular, the control unit can be a microprocessor (µP), a microcontroller (µC), a field-programmable gate array (FPGA), a programmable integrated circuit, an application-specific integrated circuit (ASIC), or so on, but not limited.

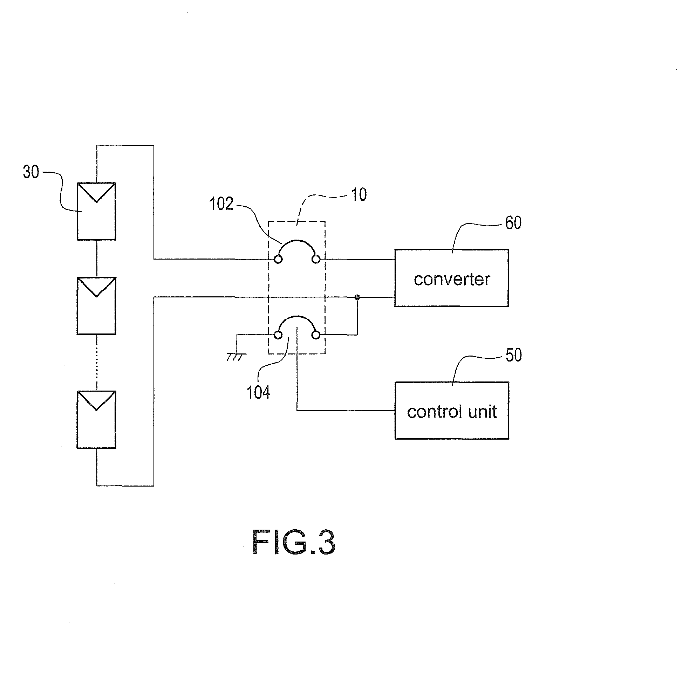

Reference is made to Fig. 3 which is a schematic circuit block diagram of an integrated circuit breaker module according to the present invention. In a solar power system, a converter 60 is supplied by a photovoltaic panel assembly 30 which is composed of a plurality of photovoltaic panels. In particular, the converter 60 could be a PV charger with a DC output voltage or an inverter with an AC output voltage. An integrated circuit breaker module 10 is electrically connected between the photovoltaic panel assembly 30 and the converter 60 for providing a grounding fault protection, an over-current fault protection, and a short-circuit fault protection. In particular, the integrated circuit breaker module 10 includes at least one first circuit breaker 102 and at least one second circuit breaker 104. The first circuit breaker 102 is used to provide a short-circuit fault protection under a high-rated current operation; the second circuit breaker 104 is used to provide a grounding fault protection under a low-rated current operation. The first circuit breaker 102 and the second circuit breaker 104 are integrated into a module. In addition, a linking unit (not shown), which is connected between the first circuit breaker 102 and the second circuit breaker 104, is provided to simultaneously trip the first circuit breaker 102 and the second circuit breaker 104. When a grounding fault occurs in the solar power system, the second circuit breaker 104 is tripped and the first circuit breaker 102 is simultaneously tripped by the linking unit to execute a grounding fault protection, an over-current fault protection, and a short-circuit fault protection. In addition, the first circuit breaker 102 is tripped and the second circuit breaker 104 is simultaneously tripped by the linking unit to execute the grounding fault protection, the over-current fault protection, and the short-circuit fault protection when a short-circuit fault occurs in the solar power system.

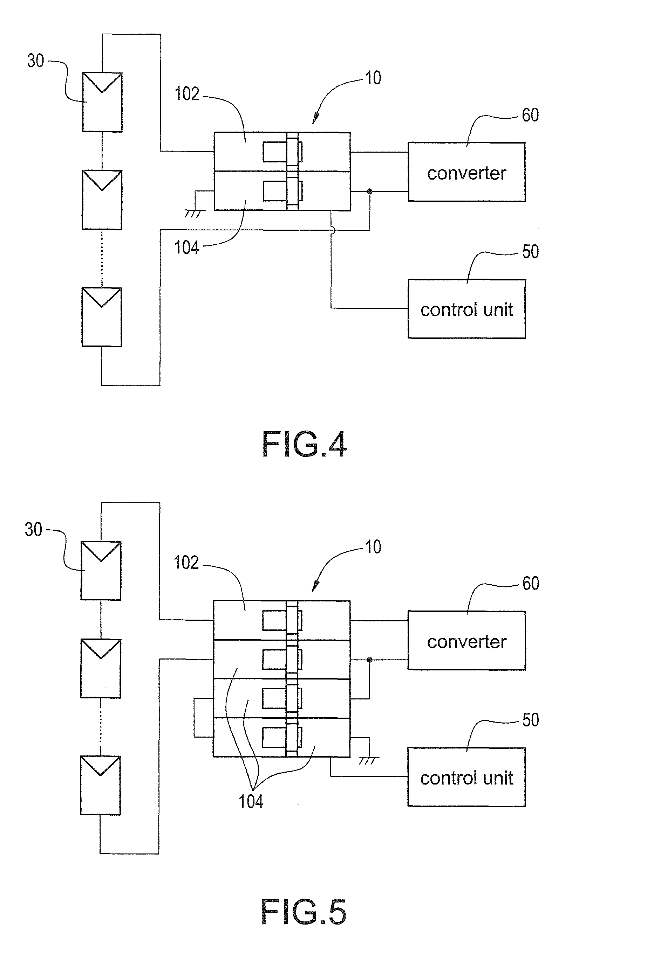

Reference is made to Fig. 4 is a schematic circuit block diagram of applying the integrated circuit breaker module in a low-voltage solar power system. When the photovoltaic panel assembly 30 is operated under a low-voltage condition (namely, a small number of the photovoltaic panels are used), the integrated circuit breaker module 10 can only provide one first circuit breaker 102 and one second circuit breaker 104 in series to implement the grounding fault protection, the over-current fault protection, and the short-circuit fault protection for the solar power system. Reference is made to Fig. 5 which is a schematic circuit block diagram of applying the integrated circuit breaker module in a high-voltage solar power system. When the photovoltaic panel assembly 30 is operated under a high-voltage condition (namely, a large number of the photovoltaic panels are used), the integrated circuit breaker module 10 can provide a plurality of first circuit breakers 102 and second circuit breakers 104 in series to increase withstanding voltage and rated current, thus implementing the grounding fault protection, the over-current fault protection, and the short-circuit fault protection for the solar power system. In this embodiment, it is assumed that the photovoltaic panel assembly 30 includes ten photovoltaic panels and each of the photovoltaic panels can provide a 40-volt rated output voltage. Hence, the photovoltaic panel assembly 30 can provide the maximum output voltage is 400 volts. For this reason, the required withstand voltage level of the first circuit breakers 102 and the second circuit breakers 104 is greater than or equal to 400 volts.

Especially to deserve to be mentioned, the first circuit breaker 102 has an auxiliary switch or an alarm switch therein. The auxiliary switch is used to detect conditions of turning on or turning off the first circuit breaker 102; the alarm switch is used to detect causes of manual tripping or overloading automatic tripping the first circuit breaker 102, such as the grounding fault, the over-current fault, the short-circuit fault, or so on. Similarly, the second circuit breaker 104 has an auxiliary switch or an alarm switch therein. The auxiliary switch is used to detect conditions of turning on or turning off the second circuit breaker 104; the alarm switch is used to detect causes of manual tripping or overloading automatic tripping the second circuit breaker 104 such as the grounding fault, the over-current fault, the short-circuit fault, or so on. In particular, the auxiliary switch and the alarm switch of the first circuit breaker 102 are controlled by a control unit 50 to detect conditions of turning on or turning off the first circuit breaker 102 and causes of manual tripping or overloading automatic tripping the first circuit breaker 102. Similarly, the auxiliary switch and the alarm switch of the second circuit breaker 104 are controlled by the control unit 50 to detect conditions of turning on or turning off the second circuit breaker 104 and causes of manual tripping or overloading automatic tripping the second circuit breaker 104. Note that, the control unit can be a microprocessor (µP), a microcontroller (µC), a field-programmable gate array (FPGA), a programmable integrated circuit, an application-specific integrated circuit (ASIC), or so on, but not limited.

Furthermore, the polarity of connecting the first circuit breaker 102 and the second circuit breaker 104 to the photovoltaic panel assembly 30 is not limited. In other words, the first circuit breaker 102 is electrically connected to a positive-polarity output of the photovoltaic panel assembly 30, whereas the second circuit breaker 104 is electrically connected to a negative-polarity output of the photovoltaic panel assembly 30, as shown in Fig. 5. Similarly, the first circuit breaker 102 is electrically connected to the negative-polarity output of the photovoltaic panel assembly 30, whereas the second circuit breaker 104 is electrically connected to a positive-polarity output of the photovoltaic panel assembly 30. Therefore, that is to increase flexibility in the use of the integrated circuit breaker module 10.

In conclusion, the present invention has following advantages:
1. The integrated circuit breaker module 10 is used to provide the grounding fault protection, the over-current fault protection, and the short-circuit fault protection for the solar power system;
2. The circuit breakers with different rated trip currents, especially to a rated current difference which is more than ten times, are simultaneously tripped by a predetermined force produced from the linking unit, thus completely protecting the solar power system as soon as abnormal faults occur; and
3. It is convenient and simple to install, detect, and control the circuits as well as reduce costs because the disconnect switch is removed and the circuit breakers are integrated into a module.

## Claims

1. A method of operating an integrated circuit breaker module (10), the integrated circuit breaker module (10) operated in a solar power system and providing a grounding fault operation, an over-current fault protection, and a short-circuit fault protection, the method comprising:
(a) providing a first circuit breaker (102) to provide a short-circuit fault protection under a high-rated current operation;
(b) providing a second circuit breaker (104) to provide a grounding fault protection under a low-rated current operation;
(c) integrating the first circuit breaker (102) and the second circuit breaker (104) into a module, providing a linking unit, and connecting the linking unit between the first circuit breaker (102) and the second circuit breaker (104) to simultaneously trip the first circuit breaker (102) and the second circuit breaker (104);
(d) tripping the second circuit breaker (104) and simultaneously tripping the first circuit breaker (102) by the linking unit to execute a grounding fault protection, an over-current fault protection, and a short-circuit fault protection when a grounding fault occurs in the solar power system.

2. The method of operating the integrated circuit breaker module of claim 1, in the step (d) further comprising:
tripping the first circuit breaker (102) and simultaneously tripping the second circuit breaker (104) to execute a grounding fault protection, an over-current fault protection, and a short-circuit fault protection when a short-circuit fault occurs in the solar power system.

3. The method of operating the integrated circuit breaker module of claim 1, wherein the first circuit breaker (102) and the second circuit breaker (104) has an alarm switch respectively, for detecting causes of tripping the first circuit breaker (102) and the second circuit breaker (104).

4. The method of operating the integrated circuit breaker module of claim 1, wherein the first circuit breaker (102) and the second circuit breaker (104) has an auxiliary switch respectively, for detecting conditions of turning on or turning off the first circuit breaker (102) and the second circuit breaker (104).

5. The method of operating the integrated circuit breaker module of claim 3, wherein the alarm switch of the first circuit breaker (102) and the alarm switch of the second circuit breaker (104) are controlled by a control unit (50) to detect causes of tripping the first circuit breaker (102) and the second circuit breaker (104) respectively.

6. The method of operating the integrated circuit breaker module of claim 4, wherein the auxiliary switch of the first circuit breaker (102) and the auxiliary switch of the second circuit breaker (104) are controlled by a control unit (50) to detect conditions of turning on or turning off the first circuit breaker (102) and the second circuit breaker (104) respectively.

7. The method of operating the integrated circuit breaker module of claim 1, wherein the first circuit breaker (102) or the second circuit breaker (104) are connected in parallel.

8. The method of operating the integrated circuit breaker module of claim 7, wherein the number of the first circuit breaker (102) or the second circuit breaker (104) is added to withstand high voltage.

9. The method of operating the integrated circuit breaker module of claim 1, wherein the second circuit breaker (104) has one terminal which is grounded for the grounding fault protection operation.

10. The method of operating the integrated circuit breaker module of claim 1, wherein the linking unit has a predetermined force to simultaneously trip the first circuit breaker (102) and the second circuit breaker (104).

11. The method of operating the integrated circuit breaker module of claim 1, wherein the first circuit breaker (102) and the second circuit breaker (104) are electrically connected to different output polarities of a photovoltaic panel assembly (30) of the solar power system, wherein the output polarities are a positive polarity and a negative polarity.
